(19) Europäisches Patentamt
European Patent Office
Office européen des brevets

(11) EP 4 632 784 A1

(12) EUROPEAN PATENT APPLICATION
published in accordance with Art. 153(4) EPC

(43) Date of publication:
15.10.2025 Bulletin 2025/42

(51) International Patent Classification (IPC):
H01J 37/08 (2006.01)

(21) Application number: 23899368.7

(22) Date of filing: 27.06.2023

(52) Cooperative Patent Classification (CPC):
H01J 9/14; H01J 37/08; H01J 37/147; H01L 21/67

(86) International application number:
PCT/CN2023/102680

(87) International publication number:
WO 2024/119781 (13.06.2024 Gazette 2024/24)

(84) Designated Contracting States:
AL AT BE BG CH CY CZ DE DK EE ES FI FR GB GR HR HU IE IS IT LI LT LU LV MC ME MK MT NL NO PL PT RO RS SE SI SK SM TR
Designated Extension States:
BA
Designated Validation States:
KH MA MD TN

(30) Priority: 06.12.2022 CN 202211578850

(71) Applicant: Jiangsu Leuven Instruments Co. Ltd
Xuzhou, Jiangsu 221300 (CN)

(72) Inventors:
• YAN, Kuicheng
  Xuzhou, Jiangsu 221300 (CN)
• YANG, Zhen
  Xuzhou, Jiangsu 221300 (CN)
• CHEN, Longbao
  Xuzhou, Jiangsu 221300 (CN)
• LIU, Haiyang
  Xuzhou, Jiangsu 221300 (CN)
• GUO, Song
  Xuzhou, Jiangsu 221300 (CN)
• HU, Dongdong
  Xuzhou, Jiangsu 221300 (CN)
• SHI, Xiaoli
  Xuzhou, Jiangsu 221300 (CN)
• XU, Kaidong
  Xuzhou, Jiangsu 221300 (CN)

(74) Representative: Eisenführ Speiser
Patentanwälte Rechtsanwälte PartGmbB
Postfach 10 60 78
28060 Bremen (DE)

(54) ION BEAM DEVICE, ION SOURCE APPARATUS AND GRID STRUCTURE THEREOF

(57) Disclosed are an ion beam device, an ion source apparatus and a grid structure thereof. The grid structure is used to guide out an ion beam. The grid structure comprises screen grids (1, 1a, 1b, 1c, 1d, 1e) and acceleration grids (2, 2a, 2b, 2c, 2d, 2e), the two being arranged in parallel at intervals. Along a direction perpendicular to the direction of the ion beam being guided out, an equivalent distance of the grid structure has an increasing trend or a decreasing trend, the equivalent distance being the sum of the equivalent thickness of the screen grids (1, 1a, 1b, 1c, 1d, 1e) and the distance between the screen grids (1, 1a, 1b, 1c, 1d, 1e) and the acceleration grids (2, 2a, 2b, 2c, 2d, 2e). By means of optimizing the grid structure of the ion source apparatus, the overall uniformity of an inclined grating can be ensured during inclined grating processing, the cost is low, and the efficiency is high.

FIG. 3

## Description

The present application claims the priority to the Chinese Patent Application No. 202211578850.0, titled "ION BEAM DEVICE, ION SOURCE APPARATUS AND GRID STRUCTURE THEREOF", filed on December 6, 2022, with the China National Intellectual Property Administration, which is incorporated herein by reference in its entirety.

## FIELD

The present disclosure relates to the technical field of ion beam devices, and in particular to an ion beam device, an ion source apparatus, and a grid structure of the ion source apparatus.

## BACKGROUND

Nowadays, ion beam processing is an important technique in micro/nano precision manufacturing. An ion source is a key component for the ion beam processing, and an ion grid structure is a crucial part of the ion source. During the ion beam processing, ions are extracted from a discharge chamber to obtain a desired ion beam, and the ion grid structure plays a key role in the extraction.

The ion grid structure is located near an outlet of the discharge chamber. Through altering a geometric feature and a relative position of grids and controlling a potential distribution on the grids, the ion grid structure can extract ions from the discharge chamber of the discharge chamber and shape the ions into a beam having a certain spatial concentration and a certain spatial pattern.

A grating is an optical element that utilizes the principle of multi-slit diffraction to disperse light into a spectrum. The gratings may be fabricated using ion beam devices. An optical waveguide is an optical component which has been developed due to a demand for augmented reality (AR) glasses. The optical waveguides have raised a high demand for slanted gratings because the slanted gratings have high diffraction efficiency.

When fabricating the slanted grating through ion beam etching, a wafer needs to be placed with a certain oblique angle with respect to the grid structure of the ion source. Hence, distinct parts of the wafer have different etching distances to the grid structure and thus have different etching rates, which result in poor uniformity across the entire wafer. At present, a part of the wafer having the higher etching rate may be coated with a thicker photoresist, and parameters of the processing are iteratively adjusted until reaching satisfactory uniformity across the entire wafer. The solution is costly and inefficient.

## SUMMARY

An ion beam device, an ion source apparatus, and a grid structure of the ion source apparatus are provided according to embodiments of the present disclosure. The grid structure of the ion source apparatus is optimized to ensure overall uniformity of a slanted grating during manufacture of the slanted grating, and the manufacture is cost-effective and efficient.

A grid structure of an ion source apparatus is provided according to embodiments of the present disclosure. The grid structure is configured for extracting an ion beam. The grid structure comprises a screen grid and an acceleration grid, which are arranged in parallel and are spaced apart. An equivalent distance of the grid structure increases or decreases monotonically along a direction perpendicular to a direction along which the ion beam is extracted. The equivalent distance is a sum of an equivalent thickness of the screen grid and a distance between the screen grid and the acceleration grid.

In an embodiment, the distance between the screen grid and the acceleration grid is constant, and the equivalent thickness of the screen grid increases or decreases monotonically, along the direction perpendicular to the direction along which the ion beam is extracted.

In an embodiment, each grid aperture on the screen grid is a cylindrical hole, where a diameter of the cylindrical hole is constant along a depth direction of the cylindrical hole. A thickness of the screen grid increases or decreases stepwise along the direction perpendicular to the direction along which the ion beam is extracted.

In an embodiment, each grid aperture on the screen grid is a cylindrical hole, where a diameter of the cylindrical hole is constant along a depth direction of the cylindrical hole. A thickness of the screen grid increases or decreases gradually along the direction perpendicular to the direction along which the ion beam is extracted.

In an embodiment, a thickness of the screen grid increases or decreases linearly along the direction perpendicular to the direction along which the ion beam is extracted.

In an embodiment, depths of grid apertures on the screen grid are identical, each grid aperture on the screen grid comprises a first aperture section and a second aperture section, and the first aperture section is located at a side of the second aperture section away from the acceleration grid. A diameter of the first aperture section decreases gradually along a direction pointing from the first aperture section to the second aperture section. A diameter of the second aperture section is constant along a depth direction of the grid aperture. The depth of the second aperture section serves as the equivalent thickness of the screen grid. The depths of the second aperture sections of the grid apertures on the screen grid increase or decrease stepwise along the direction perpendicular to the direction along which the ion beam is extracted.

In an embodiment, depths of grid apertures on the screen grid are identical, each grid aperture on the screen grid comprises a first aperture section and a second aperture section, and the first aperture section is located at a side of the second aperture section away from the acceleration grid. A diameter of the first aperture section decreases gradually along a direction pointing from the first aperture section to the second aperture section. A diameter of the second aperture section is constant along a depth direction of the grid aperture. The depth of the second aperture section serves as the equivalent thickness of the screen grid. The depths of the second aperture sections of the grid apertures on the screen grid increase or decrease gradually along the direction perpendicular to the direction along which the ion beam is extracted.

In an embodiment, the depths of the second aperture sections of the grid apertures on the screen grid increase or decrease linearly along the direction perpendicular to the direction along which the ion beam is extracted.

In an embodiment, the equivalent thickness of the screen grid is constant, and the distance between the screen grid and the acceleration grid increases or decreases monotonically, along the direction perpendicular to the direction along which the ion beam is extracted.

In an embodiment, the distance between the screen grid and the acceleration grid increases or decreases stepwise along the direction perpendicular to the direction along which the ion beam is extracted.

In an embodiment, the distance between the screen grid and the acceleration grid increases or decreases gradually along the direction perpendicular to the direction along which the ion beam is extracted.

In an embodiment, the distance between the screen grid and the acceleration grid increases or decreases linearly along the direction perpendicular to the direction along which the ion beam is extracted.

In an embodiment, the thickness of the screen grid is uniform, and each grid aperture on the screen grid is a cylindrical hole, where a diameter of the cylindrical hole is constant along a depth direction of the cylindrical hole.

In an embodiment, each grid aperture on the screen grid comprises a first aperture section and a second aperture section, and the first aperture section is located at a side of the second aperture section away from the acceleration grid. A diameter of the first aperture section decreases gradually along a direction pointing from the first aperture section to the second aperture section. A diameter of the second aperture section is constant along a depth direction of the grid aperture. The depth of the second aperture section serves as the equivalent thickness of the screen grid.

In an embodiment, the equivalent thickness of the screen grid and the distance between the screen grid and the acceleration grid both increase monotonically or both decrease monotonically, along the direction perpendicular to the direction along which the ion beam is extracted.

In an embodiment, the equivalent thickness of the screen grid increases or decreases stepwise along the direction perpendicular to the direction along which the ion beam is extracted.

In an embodiment, the equivalent thickness of the screen grid increases or decreases linearly along the direction perpendicular to the direction along which the ion beam is extracted.

In an embodiment, the distance between the screen grid and the acceleration grid increases or decreases stepwise along the direction perpendicular to the direction along which the ion beam is extracted.

In an embodiment, the distance between the screen grid and the acceleration grid increases or decreases linearly along the direction perpendicular to the direction along which the ion beam is extracted.

An ion source apparatus is further provided according to an embodiment of the present disclosure. The ion source apparatus comprises any foregoing grid structure, and the grid structure is located at an outlet of the ion source apparatus.

An ion beam device is further provided according to an embodiment of the present disclosure. The ion beam device comprises the above ion source apparatus.

Addressed is an issue of poor wafer uniformity due to non-uniform etching distance when slanted gratings are fabricated with ion beam etching in related art. The grid structure of the ion source apparatus in the ion beam device is improved. The screen grid and the acceleration grid within the grid structure are adjusted such that the equivalent distance of the grid structure is increasing or decreasing monotonically along the direction perpendicular to the direction of extracting the ion beam. The adjustment alters a current emitted from a single grid aperture on the grid structure and thus changes a density of the extracted ion beam along the direction perpendicular to the direction of extracting the ion beam. This approach can enhance the etching rate in an area of the slanted grating subject to slow etching and reduce the etching rate in an area subject to fast etching. Hence, overall uniformity of fabricating the slanted grating is improved. Furthermore, it is not necessary to iteratively adjust parameters of etching, which facilitates high efficiency and low costs.

The ion source apparatus and the ion beam device provided herein comprise the above grid structure and hence share the same technical effects.

## BRIEF DESCRIPTION OF THE DRAWINGS

FIG. 1 is a schematic view of a single grid aperture in a grid structure according to an embodiment of the present disclosure.

FIGs. 2A and 2B are schematic structural views of a grid structure according to a first embodiment of the present disclosure.

FIG. 3 is a schematic view illustrating a positional relationship between a grid structure as shown in FIG. 2A and a wafer according to an embodiment of the present disclosure.

FIGs. 4A and 4B are schematic structural views of a grid structure according to a second embodiment of the present disclosure.

FIG. 5 is a schematic structural view of a grid structure according to a third embodiment of the present disclosure.

FIG. 6 is a schematic view illustrating a positional relationship between a grid structure as shown in FIG. 5 and a wafer according to an embodiment of the present disclosure.

FIG. 7 is a schematic structural view of a grid structure according to a fourth embodiment of the present disclosure.

FIGs. 8A and 8B are schematic structural views of a grid structure according to a fifth embodiment of the present disclosure.

FIG. 9 is a schematic structural view of a single grid aperture in the grid structure according to the fifth embodiment of the present disclosure.

FIG. 10 is a simplified structural view of a variant of a grid structure according to an embodiment of the present disclosure.

Reference numerals:

| 1, 1a, 1b, 1c,1d, 1e: | screen grid, | | |
| 11e: | first aperture section, | 12e: | second aperture section, |
| 2, 2a, 2b, 2c,2d, 2e: | acceleration grid, | | |
| 3: | wafer; | | |
| A1, A1', A1": | first region, | A2, A2', A2": | second region, |
| A3, A3', A3": | third region; | | |
| S: | ion beam, | S1: | first ion beam, |
| S2: | second ion beam, | S3: | third ion beam. |

## DETAILED DESCRIPTION OF THE EMBODIMENTS

Herein a grid structure of an ion source apparatus is studied to address an issue of poor wafer uniformity due to non-uniform etching distance when a slanted grating is manufactured through ion beam etching in related art.

A grid structure of an ion source comprises a screen grid and an acceleration grid, which are placed in parallel with each other. The screen grid and the acceleration grid are essential components for extracting and accelerating ions. Along a direction of extracting the ions, the acceleration grid is located at a side of the screen grid facing an outlet of the ion source. That is, the acceleration grid is closer to the wafer than the screen grid.

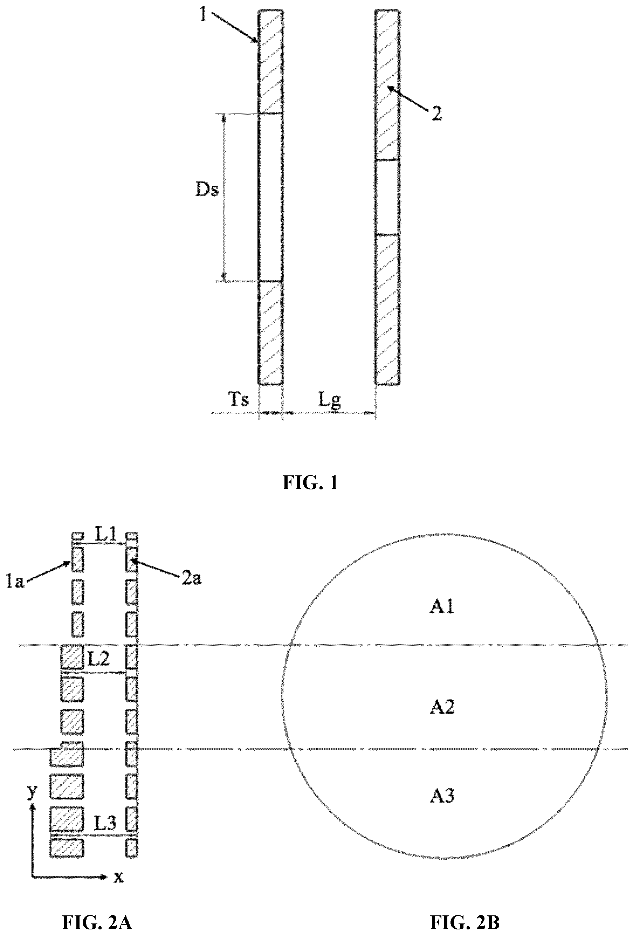

Reference is made to FIG. 1. An equation for calculating a current emitted from a single grid aperture in the grid structure is as follows.

$$I \approx \frac{4\pi\varepsilon_0}{9} \sqrt{\frac{2e}{M}} V_T^{\frac{3}{2}} \frac{1}{1+4\left(\frac{Lg+T_S}{D_S}\right)^2}$$

Lg represents a distance between the screen grid 1 and the acceleration grid 2. Ts represents an equivalent thickness of the screen grid 1. Lg + Ts is called an equivalent distance of the grid structure, that is, the equivalent distance of the grid structure is a sum of the equivalent thickness of the screen grid and the distance between the screen grid and the acceleration grid. The equation indicates that the current I is negatively correlated with the equivalent distance Lg + Ts of the grid structure. That is, a smaller equivalent distance Lg + Ts of the grid structure leads to a larger current I, and a larger equivalent distance Lg + Ts of the grid structure leads to a smaller current I. The current emitted from the single grid aperture in the grid structure affects a density of the extracted ion beam directly. A larger current leads to a greater density of the extracted ion beam, and vice versa.

Herein the grid structure is improved on a basis of the above analysis. The equivalent distance of the grid structure increases monotonically or decreases monotonically along a direction perpendicular to the direction along which the ion beam is extracted.

In a simple embodiment, grid apertures are distributed in an area of the grid structure, and the area is divided into at least two regions. The at least two regions are sequentially arranged along the direction perpendicular to the direction along which the ion beam is extracted. In the arrangement direction, the equivalent distance of the grid structure in a region is smaller than the equivalent distance of the grid structure in another region that is subsequent to such region in the sequence, or the equivalent distance of the grid structure in a region is greater than the equivalent distance of the grid structure in another region that is subsequent to such region in the sequence.

The above configuration makes the equivalent distance of the grid structure follow a trend of a monotonical increase or a monotonical decrease in the direction perpendicular to the direction along which the ion beam is extracted. Hence, the current emitted from the single grid aperture on the grid structure is altered and the density of the extracted ion beam is also altered along the direction perpendicular to the direction of extracting the ion beam. When a slanted grating is fabricated through etching, the region having a smaller equivalent distance of the grid structure can be disposed at a larger distance from a wafer, while the region having a larger equivalent distance of the grid structure can be disposed at a smaller distance from the wafer. This approach can enhance the etching rate in an area of the slanted grating subject to slow etching and reduce the etching rate in an area subject to fast etching. Hence, overall uniformity of fabricating the slanted grating is improved. Furthermore, it is not necessary to iteratively adjust parameters of etching, which facilitates high efficiency and low costs.

Hereinafter the present disclosure is illustrated in detail in conjunction with the drawings and embodiments to help those skilled in the art understand technical solutions of the present disclosure.

Hereinafter the direction along which the ion beam is extracted from the grid structure is defined as a direction of an x-axis, and the direction perpendicular to the direction along which the ion beam is extracted is defined as a direction of a y-axis. A plane in which the screen grid or the acceleration grid of the grid structure is disposed is parallel to the y-axis direction and perpendicular to the x-axis direction. The above definitions are intended for helping illustration and understanding.

**First Example**

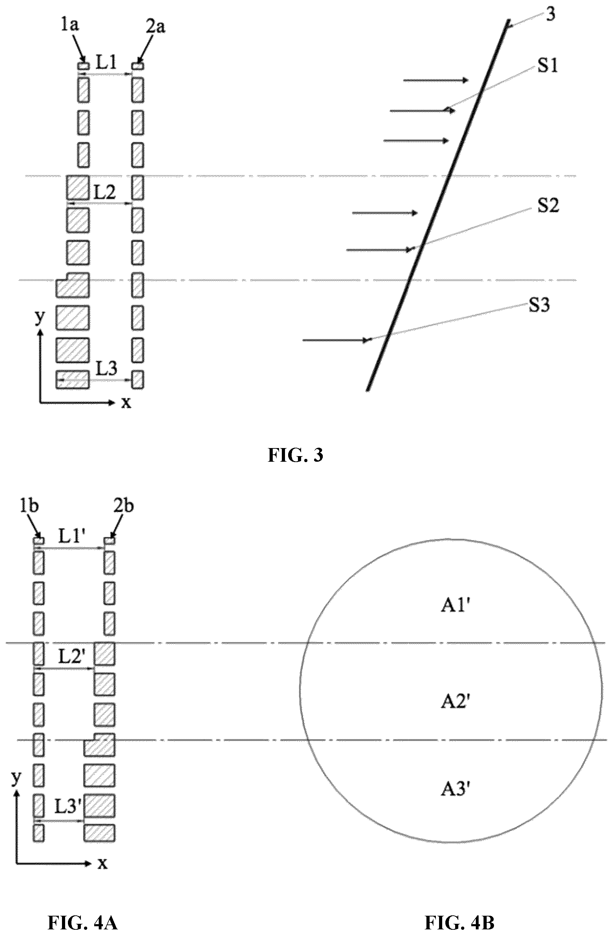

Reference is made to FIGs. 2A, 2B and 3. FIGs. 2A and 2B are schematic structural views of a grid structure according to a first embodiment of the present disclosure, and FIG. 3 is a schematic view illustrating a positional relationship between a grid structure as shown in FIG. 2A and a wafer according to an embodiment of the present disclosure.

In an embodiment, the grid structure of the ion source apparatus comprises a screen grid 1a and an acceleration grid 2a, which are arranged along the x-axis direction.

Thickness of the acceleration grid 2a is uniform, and thus grid apertures on the acceleration grid 2a have identical depths. The distance between the screen grid 1a and the acceleration grid 2a are also uniform.

Each grid aperture on the screen grid 1a is a cylindrical aperture, that is, a diameter of the grid aperture is uniform along a depth direction of such grid aperture. In other words, the diameter of a single grid aperture stays constant and does not change. It does not indicate that all grid apertures in the screen grid 1a shall be configured with the same size. Thus, the depth of each grid aperture on the screen grid 1a is identical to the thickness of the screen grid 1a at a position at which the grid aperture is located. In the cylindrical-aperture case, at the position of the grid aperture, the equivalent thickness of the screen grid 1a is equal to the thickness of the screen grid 1a.

In an embodiment, the grid structure is divided into three regions sequentially arranged along the y-axis direction, namely, a first region A1, a second region A2, and a third region A3 are arranged from top to bottom as shown in the figure.

The thickness of the screen grid 1a in the first region A1 is less than that in the second region A2, and the thickness of the screen grid 1a in the second region A2 is less than that in the third region A3. Thickness of the screen grid 1a is constant within the same region. Thus, the thickness of the screen grid 1a changes stepwise along the y-axis direction.

In the first region A1, the equivalent distance of the grid structure is L1, which is equal to the sum of the thickness of the screen grid 1a in the first region A1 and the distance between the screen grid 1a and the acceleration grid 2a. In the second region A2, the equivalent distance of the grid structure is L2, which is equal to the sum of the thickness of the screen grid 1a in the second region A2 and the distance between the screen grid 1a and the acceleration grid 2a. In the third region A3, the equivalent distance of the grid structure is L3, which is equal to the sum of the thickness of the screen grid 1a in the third region A3 and the distance between the screen grid 1a and the acceleration grid 2a. Considering the configuration of the thickness of the screen grid 1a, there is L1 < L2 < L3.

Reference is made to FIG. 3. When the above grid structure is used for fabricating a slanted grating through etching, a wafer 3 is obliquely disposed, that is, there is a non-zero angle between the surface of the wafer 3 and the y-axis direction. Hence, the distance between the wafer 3 and the grid structure changes along the y-axis direction.

In an embodiment, the wafer 3 is such disposed that an upper part of the wafer 3 is further away from the grid structure than its lower part. Thus, the distance between the first region A1 of the grid structure and the wafer 3 is greater than the distance between the second region A2 of the grid structure and the wafer 3, and the distance between the second region A2 of the grid structure and the wafer 3 is greater than the distance between the third region A3 of the grid structure and the wafer 3.

As mentioned above, the equivalent distance of the grid structure is negatively correlated with the density of the extracted ion beam. Therefore, the density of a first ion beam S1 extracted by the first region A1 of the grid structure is greater than the density of a second ion beam S2 extracted by the second region A2 of the grid structure, and the density of the second ion beam S2 extracted by the second region A2 of the grid structure is greater than the density of a third ion beam S3 extracted by the third region A3 of the grid structure. The above configuration increases the etching rate of the part (corresponding to the first region A1) of the wafer 3 that is far away from the grid structure, maintains a moderate etching rate for the part (corresponding to the second region A2) of the wafer 3 that has a moderate distance from the grid structure, and reduces the etching rate of the part (corresponding to the third region A3) that is close to the grid structure. Hence, as a synthetical effect, the uniformity of the etching on the slanted grating is improved.

In practice, the sizes of the first region A1, the second region A2, and the third region A3 of the grid structure may be configured on requirement, and the equivalent distance of each region may also be configured on requirement.

As shown in FIGS. 2A and 2B, the equivalent distance increases progressively in a sequence of the first region A1, the second region A2, and the third region A3, which are depicted from top to bottom. As an alternative solution, the equivalent distance decreases progressively in the sequence of the first region A1, the second region A2, and the third region A3, while having the same configuration in other aspects.

**Second Example**

Reference is made to FIGs. 4A and 4B. FIGS. 4A and 4B are schematic structural views of a grid structure according to a second embodiment of the present disclosure.

In an embodiment, the grid structure of the ion source apparatus comprises a screen grid 1b and an acceleration grid 2b, which are arranged along the x-axis direction.

Thickness of the screen grid 1b is uniform, and each grid aperture on the screen grid 1b is a cylindrical aperture. Details of the cylindrical aperture have been described in the first example. Thus, depth of each grid aperture on the screen grid 1b is identical to the thickness of the screen grid 1b at a position at which the grid aperture is located. The thickness of the screen grid 1b is the equivalent thickness of the screen grid 1b.

In an embodiment, the grid structure is divided into three regions sequentially arranged along the y-axis, namely, a first region A1', a second region A2', and a third region A3' are arranged from top to bottom as depicted in the figure. The distance between the screen grid 1b and the acceleration grid 2b in the first region A1' is greater than that in the second region A2', and the distance between the screen grid 1b and the acceleration grid 2b in the second region A2' is greater than that in the third region A3'. When the thickness of the screen grid 1b is uniform, thickness of the acceleration grid 2b changes stepwise along the y-axis direction to achieve the above configuration of the distance. A surface of the acceleration grid 2b away from the screen grid 1b may be parallel to the y-axis.

Reference is further made to FIGs. 4A and 4B. In the first region A1', the equivalent distance of the grid structure is L1', which is equal to the sum of the thickness of the screen grid 1b and the distance between the screen grid 1b and the acceleration grid 2b in the first region A1'. In the second region A2', the equivalent distance of the grid structure is L2', which is equal to the sum of the thickness of the screen grid 1b and the distance between the screen grid 1b and the acceleration grid 2b in the second region A2'. In the third region A3', the equivalent distance of the grid structure is L3', which is equal to the sum of the thickness of the screen grid 1b and the distance between the screen grid 1b and the acceleration grid 2b in the third region A3'. Considering the configuration of the distance between the screen grid 1b and the acceleration grid 2b, there is L1' > L2' > L3'.

As mentioned above, the equivalent distance of the grid structure is negatively correlated with the density of the extracted ion beam. Therefore, the density of the ion beam extracted by the first region A1' of the grid structure is less than the density of the ion beam extracted by the second region A2' of the grid structure, and the density of the ion beam extracted by the second region A2' of the grid structure is less than the density of the ion beam extracted by the third region A3' of the grid structure.

When the above grid structure is used for fabricating a slanted grating through etching, the wafer 3 is obliquely disposed with respect to the grid structure. The aforementioned angle may be adjusted to balance the etching rates in different regions and improve the overall etching uniformity.

Reference is further made to FIGs. 4A and 4B. The equivalent distance of the grid structure decreases progressively in the sequence of the first region A1', the second region A2', and the third region A3', which are depicted from top to bottom. As an alternative solution, the equivalent distance increases progressively in the sequence of the first region A1', the second region A2', and the third region A3', while having the same configuration in other aspects.

**Third Example**

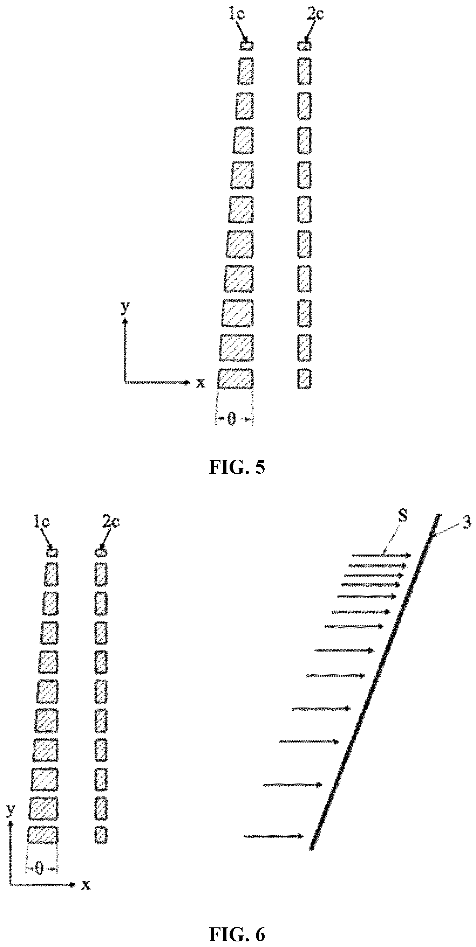

Reference is made to FIGs. 5 and 6. FIG. 5 is a schematic structural view of a grid structure according to a third embodiment of the present disclosure, and FIG. 6 is a schematic view illustrating a positional relationship between a grid structure as shown in FIG. 5 and a wafer according to an embodiment of the present disclosure.

In an embodiment, the grid structure of the ion source apparatus comprises a screen grid 1c and an acceleration grid 2c, which are arranged along the x-axis direction.

Thickness of the acceleration grid 2c is unformed, and thus grid apertures on the acceleration grid 2c have identical depths. The distance between the screen grid 1c and the acceleration grid 2c is also uniform.

Each grid aperture on the screen grid 1c is a cylindrical aperture, and details of the cylindrical aperture have been described in the first example. Thus, the depth of each grid aperture in the screen grid 1c is identical to the thickness of the screen grid 1c at a position at which the grid aperture is located. At the position of the grid aperture, the equivalent thickness of the screen grid 1c is the thickness of the screen grid 1c.

As depicted in FIG. 5, the thickness of the screen grid 1c may increase gradually from top to bottom along the y-axis direction. In an embodiment, the thickness of the screen grid 1c changes linearly along the y-axis direction. That is, a surface of the screen grid 1c away from the acceleration grid 2c forms a slope, and the equivalent thickness of the screen grid 1c increases linearly along the y-axis direction. Since the distance between the screen grid 1c and the acceleration grid 2c are uniform, the equivalent distance of the grid structure also increases linearly along the y-axis direction.

As another perspective, the above grid structure is divided into multiple regions arranged from top to bottom as depicted along the y-axis direction, and the equivalent distance of the grid structure increases gradually from top to bottom.

Reference is made to FIG. 6. When the above grid structure is used for fabricating a slanted grating through etching, a wafer 3 is obliquely disposed, that is, there is a non-zero angle between the surface of the wafer 3 and the y-axis direction. Hence, the distance between the wafer 3 and the grid structure changes along the y-axis direction.

In an embodiment, the wafer 3 is such disposed that an upper part of the wafer 3 is further away from the grid structure than its lower part. Thus, as depicted, the distance between the grid structure and the wafer 3 decreases gradually from top to bottom along the y-axis direction. Since the equivalent distance of the grid structure gradually increases from top to bottom along the y-axis direction as mentioned above, the density of the ion beam emitted by the grid structure decreases gradually from top to bottom along the y-axis direction. Consequently, the etching rate of the part of the wafer 3 far away from the grid structure is enhanced, and the etching rate of the part of the wafer 3 close to the grid structure is reduced. Hence, as a synthetical effect, the uniformity of the etching on the slanted grating is improved.

Here the arrangement of the screen grid 1c leads to an included angle θ between its two side surfaces opposite to each other along the x-axis. Magnitude of the angle θ determines a rate of change in the equivalent thickness of the screen grid 1c along the y-axis direction. The angle θ may be set on requirement. Generally, the angle θ is greater than zero and smaller than 90 degrees.

As shown in FIG. 5, the thickness of the screen grid 1c increases linearly from top to bottom along the y-axis direction. As an alternative scheme, the thickness of the screen grid 1c may not change linearly but increase with a varying rate. As another alternative scheme, the thickness of the screen grid 1c may decrease gradually from top to bottom along the y-axis direction.

**Fourth Example**

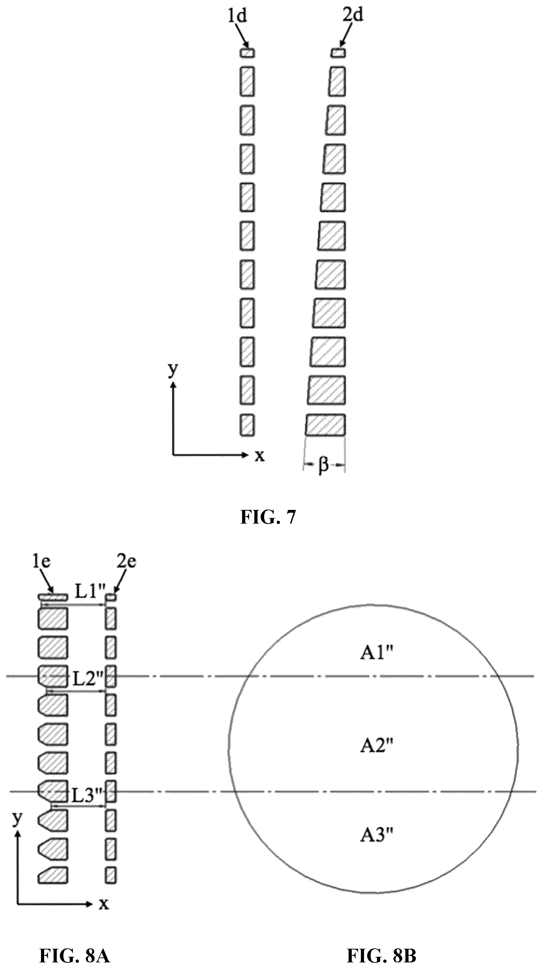

Reference is made to FIG. 7. FIG. 7 is a schematic structural view of a grid structure according to a fourth embodiment of the present disclosure.

In an embodiment, the grid structure of the ion source apparatus comprises a screen grid 1d and an acceleration grid 2d, which are arranged along the x-axis direction.

Thickness of the screen grid 1d is uniform, and each grid aperture on the screen grid 1d is a cylindrical aperture. Details of the cylindrical aperture have been described in the first example. Thus, depth of each grid aperture on the screen grid 1d is identical to the thickness of the screen grid 1d at a position at which the grid aperture is located. The thickness of the screen grid 1b is the equivalent thickness of the screen grid 1b.

The distance between the screen grid 1d and the acceleration grid 2d may decrease gradually from top to bottom along the y-axis direction as depicted in the figure. In an embodiment, the distance between the screen grid 1d and the acceleration grid 2d decreases linearly. A side surface of the acceleration grid 2d facing the screen grid 1d is inclined to achieve the above configuration of the distance. Hence, there is an included angle β between the two side surfaces of the acceleration grid 2d, which are opposite to each other along the x-axis. Magnitude of this angle β is determines a rate of change in the equivalent thickness of the screen grid 1d along the y-axis direction. The angle β may be set on requirement. Generally, the angle β is greater than zero and smaller than 90 degrees.

Similar to the third example, the above grid structure can be treated as being divided into multiple regions arranged from top to bottom as depicted along the y-axis direction, and the equivalent distance of the grid structure decreases gradually from top to bottom.

The above grid structure can also improve the uniformity of fabrication of the slanted grating through etching, where a principle may refer to the above embodiments.

As shown in FIG. 6, the distance between the screen grid 1d and the acceleration grid 2d decreases linearly from top to bottom along the y-axis direction. As an alternative scheme, the distance between the screen grid 1d and the acceleration grid 2d may not change linearly but decrease with a varying rate. As another alternative scheme, the distance between the screen grid 1d and the acceleration grid 2d may decrease gradually from top to bottom along the y-axis direction.

**Fifth Example**

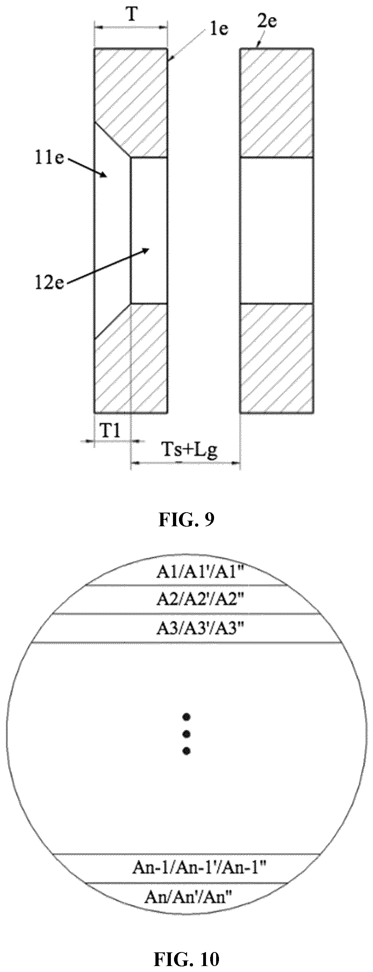

Reference is made to FIGs. 8A, 8B and 9. FIGs. 8A and 8B are schematic structural views of a grid structure according to a fifth embodiment of the present disclosure, and FIG. 9 is a schematic structural view of a single grid aperture of the grid structure in the fifth embodiment.

In an embodiment, the grid structure of the ion source apparatus comprises a screen grid 1e and an acceleration grid 2e, which are arranged in the x-axis direction.

Thickness of the acceleration grid 2e is unformed, and thus grid apertures on the acceleration grid 2e have identical depths. The distance between the screen grid 1e and the acceleration grid 2e is also uniform.

Thickness of the screen grid 1e is uniform, and grid apertures on the screen grid 1e have identical depths. That is, thickness of the screen grid 1e is constant at a position of each grid aperture. As shown in FIG. 9, the thickness of the screen grid 1e is T, and a total depth of each single grid aperture is also T. Each grid aperture of the screen grid 1e comprises a first aperture section 11e and a second aperture section 12e. The first aperture section 11e is located at a side of the second aperture section 12e away from the acceleration grid 2e, and a diameter of the first aperture section 11e decreases gradually in a direction point from the first aperture section 11e to the second aperture section 12e. The second aperture section 12e is a cylindrical aperture. In such configuration, the equivalent thickness Ts of the screen grid 1e at the position of the single grid aperture is the depth of the second aperture section 12e. Reference is made to FIG. 9, where the equivalent thickness is Ts = T - T1, T1 is a depth of the first aperture section 11e.

In an embodiment, the grid structure is divided into three regions sequentially arranged along the y-axis direction, namely, a first region A1", a second region A2", and a third region A3" are arranged from top to bottom as shown in the figure. The equivalent thickness of the screen grid 1e in the first region A1" is greater than that in the second region A2", that is, the depth of the second aperture section 12e in the first region A1" is greater than that in the second region A2". The equivalent thickness of the screen grid 1e in the second region A2" is greater than that in the third region A3", that is, the depth of the second aperture section 12e in the second region A2" is greater than that in the third region A3". Thus, the equivalent thickness of the screen grid 1d changes stepwise along the y-axis direction.

In the first region A1", the equivalent distance of the grid structure is L1", which is equal to the sum of the thickness of the screen grid 1e in the first region A1" and the distance between the screen grid 1e and the acceleration grid 2e. In the second region A2", the equivalent distance of the grid structure is L2", which is equal to the sum of the thickness of the screen grid 1e in the second region A2" and the distance between the screen grid 1a and the acceleration grid 2a. In the third region A3", the equivalent distance of the grid structure is L3", which is equal to the sum of the thickness of the screen grid 1e in the third region A3" and the distance between the screen grid 1e and the acceleration grid 2e. Considering the configuration of the thickness of the screen grid 1e, there is L1" > L2" > L3".

As mentioned above, the equivalent distance of the grid structure is negatively correlated with the density of the extracted ion beam. Therefore, when the grid structure is utilized for fabricating a slanted grating, uniformity of etching can also be improved.

As shown in FIGS. 8A, the equivalent distance decreases progressively in a sequence of the first region A1", the second region A2", and the third region A3", which are depicted from top to bottom. As an alternative solution, the equivalent distance increases progressively in the sequence of the first region A1", the second region A2", and the third region A3", while having the same configuration in other aspects.

The grid structure is divided into three regions along the y-axis direction in some embodiments of the first example, the second example, and the fifth example. As an alternative, the quantity of the regions into which the grid structure is divided along the y-axis direction may be two, four, or more than four. Reference is made to FIG. 10. It is appreciated that when the quantity of the regions increases to a certain extent, the equivalent distance of the grid structure may exhibit approximately linear increase or decrease along the y-axis direction, which is similar to embodiments in the third example or the fourth example. It is also appreciated that the increase or decrease may have a changing rate.

In some of the above embodiments, the equivalent thickness of the screen grid is uniform, because the screen grid has uniform thickness and the grid apertures are cylindrical. As an alternative scheme, the grid aperture on the screen grid may adopt the two-section structure as shown in FIGs. 8A and 9, while keeping the equivalent thickness uniform.

As mentioned above, the equivalent distance of the grid structure is the sum of the equivalent thickness of the screen grid and the distance between the screen grid and the acceleration grid. That is, there are two parameters that affect the equivalent distance: one is the equivalent thickness of the screen grid, and the other is the distance between the screen grid and the acceleration grid. In the foregoing embodiments, the equivalent distance of the grid structure changes because one of the two parameters varies. In the first, third, and fifth examples, the equivalent thickness of the screen grid varies while the distance between the screen grid and the acceleration grid keeps constant to achieve the change of the equivalent distance. In the second and fourth examples, the distance between the screen grid and the acceleration grid changes while the equivalent thickness of the screen grid keeps constant to achieve the change of the equivalent distance.

In practice, the monotonical increase or decrease in the equivalent distance of the grid structure may alternatively be implemented through varying both parameters. In an embodiment, along the direction perpendicular to the direction along which the ion beam is extracted, the equivalent thickness of the screen grid and the distance between the screen grid and the acceleration grid both increase monotonically or both decrease monotonically. The change of the equivalent thickness of the screen grid may refer to the foregoing description concerning FIGs. 2A, 5, or 8A. The change of the distance between the screen grid and the acceleration grid may refer to the foregoing description concerning FIGs. 4A or 7.

A type of the change of the equivalent thickness of the screen grid may be identical to or different from a type of the change trend of the distance between the screen grid and the acceleration grid. As an example, the change of the equivalent thickness of the screen grid is a stepwise change, and the change of the distance between the screen grid and the acceleration grid is a stepwise change or a linear change. As another example, the change of the equivalent thickness of the screen grid is a gradual change (the gradual change including the linear change), and the change of the distance between the screen grid and the acceleration grid is a stepwise change or a gradual change.

An ion source apparatus is further provided according to an embodiment of the present disclosure. The ion source apparatus comprises the grid structure according to any foregoing embodiment. The grid structure is located at an outlet of the ion source apparatus.

An ion beam device is further provided according to an embodiment of the present disclosure. The ion source apparatus comprises the ion source apparatus. The ion beam device may be a device for ion beam etching or a device for ion beam deposition.

The ion source apparatus and the ion beam device comprise the grid structure, and hence they also have the same technical effects as the foregoing grid structures. These effects would not be repeated herein.

Hereinabove the ion beam device, the ion source apparatus, and the grid structure of the ion source apparatus are provided according to embodiments of the present disclosure and are described in detail. The principle and implementation of the present disclosure are illustrated by using specific embodiments. The above description of the embodiments is only intended for facilitating understanding of the method and the core concept of the present disclosure. Those skilled in the art may make improvements and modifications to these embodiments of the present disclosure without departing from the principle of the present disclosure, and these improvements and modifications also fall within a scope of the claims of the present disclosure.

**Claims**

1. A grid structure of an ion source apparatus, wherein:

    the grid structure is configured for extracting an ion beam and comprises a screen grid and an acceleration grid, which are arranged in parallel and are spaced apart;
    an equivalent distance of the grid structure increases or decreases monotonically along a direction perpendicular to a direction along which the ion beam is extracted; and

the equivalent distance is a sum of an equivalent thickness of the screen grid and a distance between the screen grid and the acceleration grid.

2. The grid structure according to claim 1, wherein the distance between the screen grid and the acceleration grid is constant, and the equivalent thickness of the screen grid increases or decreases monotonically, along the direction perpendicular to the direction along which the ion beam is extracted.

3. The grid structure according to claim 2, wherein:

   each grid aperture on the screen grid is a cylindrical hole, wherein a diameter of the cylindrical hole is constant along a depth direction of the cylindrical hole; and
   a thickness of the screen grid increases or decreases stepwise along the direction perpendicular to the direction along which the ion beam is extracted.

4. The grid structure according to claim 2, wherein:

   each grid aperture on the screen grid is a cylindrical hole, wherein a diameter of the cylindrical hole is constant along a depth direction of the cylindrical hole;
   a thickness of the screen grid increases or decreases gradually along the direction perpendicular to the direction along which the ion beam is extracted.

5. The grid structure according to claim 4, wherein a thickness of the screen grid increases or decreases linearly along the direction perpendicular to the direction along which the ion beam is extracted.

6. The grid structure according to claim 2, wherein:

   depths of grid apertures on the screen grid are identical, each grid aperture on the screen grid comprises a first aperture section and a second aperture section, and the first aperture section is located at a side of the second aperture section away from the acceleration grid;
   a diameter of the first aperture section decreases gradually along a direction pointing from the first aperture section to the second aperture section, and a diameter of the second aperture section is constant along a depth direction of the grid aperture;
   the depth of the second aperture section serves as the equivalent thickness of the screen grid; and
   the depths of the second aperture sections of the grid apertures on the screen grid increase or decrease stepwise along the direction perpendicular to the direction along which the ion beam is extracted.

7. The grid structure according to claim 2, wherein:

   depths of grid apertures on the screen grid are identical, each grid aperture on the screen grid comprises a first aperture section and a second aperture section, and the first aperture section is located at a side of the second aperture section away from the acceleration grid;
   a diameter of the first aperture section decreases gradually along a direction pointing from the first aperture section to the second aperture section, and a diameter of the second aperture section is constant along a depth direction of the grid aperture;
   the depth of the second aperture section serves as the equivalent thickness of the screen grid; and
   the depths of the second aperture sections of the grid apertures on the screen grid increase or decrease gradually along the direction perpendicular to the direction along which the ion beam is extracted.

8. The grid structure according to claim 7, wherein the depths of the second aperture sections of the grid apertures on the screen grid increase or decrease linearly along the direction perpendicular to the direction along which the ion beam is extracted.

9. The grid structure according to claim 1, wherein the equivalent thickness of the screen grid is constant, and the distance between the screen grid and the acceleration grid increases or decreases monotonically, along the direction perpendicular to the direction along which the ion beam is extracted.

10. The grid structure according to claim 9, wherein the distance between the screen grid and the acceleration grid increases or decreases stepwise along the direction perpendicular to the direction along which the ion beam is extracted.

11. The grid structure according to claim 9, wherein the distance between the screen grid and the acceleration grid increases or decreases gradually along the direction perpendicular to the direction along which the ion beam is extracted.

12. The grid structure according to claim 11, wherein the distance between the screen grid and the acceleration grid increases or decreases linearly along the direction perpendicular to the direction along which the ion beam is extracted.

13. The grid structure according to any one of claims 9 to 12, wherein a thickness of the screen grid is uniform, and each grid aperture on the screen grid is a cylindrical hole, wherein a diameter of the cylindrical hole is constant along a depth direction of the cylindrical hole.

14. The grid according to any one of claims 9 to 12, wherein:

each grid aperture on the screen grid comprises a first aperture section and a second aperture section, and the first aperture section is located at a side of the second aperture section away from the acceleration grid;
a diameter of the first aperture section decreases gradually along a direction pointing from the first aperture section to the second aperture section;
a diameter of the second aperture section is constant along a depth direction of the grid aperture; and
the depth of the second aperture section serves as the equivalent thickness of the screen grid.

15. The grid structure according to claim 1, wherein the equivalent thickness of the screen grid and the distance between the screen grid and the acceleration grid both increase monotonically or both decrease monotonically, along the direction perpendicular to the direction along which the ion beam is extracted.

16. The grid structure according to claim 15, wherein the equivalent thickness of the screen grid increases or decreases stepwise along the direction perpendicular to the direction along which the ion beam is extracted.

17. The grid structure according to claim 15, wherein the equivalent thickness of the screen grid increases or decreases linearly along the direction perpendicular to the direction along which the ion beam is extracted.

18. The grid structure according to claim 15, wherein the distance between the screen grid and the acceleration grid increases or decreases stepwise along the direction perpendicular to the direction along which the ion beam is extracted.

19. The grid structure according to claim 15, wherein the distance between the screen grid and the acceleration grid increases or decreases linearly along the direction perpendicular to the direction along which the ion beam is extracted.

20. An ion source apparatus, comprising:
the grid structure according to any one of claims 1 to 19, wherein the grid structure is located at an outlet of the ion source apparatus.

21. An ion beam device, comprising the ion source apparatus according to claim 20.

**FIG. 1**

**FIG. 2A**

**FIG. 2B**

**FIG. 3**

**FIG. 4A**                                                    **FIG. 4B**

**FIG. 5**

**FIG. 6**

**FIG. 7**

**FIG. 8A**

**FIG. 8B**

**FIG. 9**

**FIG. 10**

## INTERNATIONAL SEARCH REPORT

| | International application No. |
|---|---|
| | **PCT/CN2023/102680** |

**A. CLASSIFICATION OF SUBJECT MATTER**

H01J37/08(2006.01)i

According to International Patent Classification (IPC) or to both national classification and IPC

**B. FIELDS SEARCHED**

Minimum documentation searched (classification system followed by classification symbols)

IPC:H01J

Documentation searched other than minimum documentation to the extent that such documents are included in the fields searched

Electronic data base consulted during the international search (name of data base and, where practicable, search terms used)

CNABS, CNTXT, ENTXTC, VEN, DWPI: 屏栅, 加速栅, 等效距离, 距离, 间距, 增大, 减小, 渐变, , 离子源, 离子植入, 离子注入, 斜, 光栅, 加速, 引出, 栅, grid, screen, ion beam, ion source, acceleration, distance

**C. DOCUMENTS CONSIDERED TO BE RELEVANT**

| Category* | Citation of document, with indication, where appropriate, of the relevant passages | Relevant to claim No. |
|---|---|---|
| A | CN 110993474 A (CHANGCHUN INSTITUTE OF OPTICS, FINE MECHANICS AND PHYSICS, CHINESE ACADEMY OF SCIENCES) 10 April 2020 (2020-04-10) description, paragraph 4, and figure 1 | 1-21 |
| A | CN 104236426 A (LANZHOU INSTITUTE OF PHYSICS, CHINESE ACADEMY OF SPACE TECHNOLOGY) 24 December 2014 (2014-12-24) entire document | 1-21 |
| A | CN 106683966 A (BEIJING ADVANCED MEMS ION BEAM TECHNOLOGY RESEARCH INSTITUTE CO., LTD.) 17 May 2017 (2017-05-17) entire document | 1-21 |
| A | JP 2003139044 A (MITSUBISHI ELECTRIC CORP.) 14 May 2003 (2003-05-14) entire document | 1-21 |
| A | US 2013299722 A1 (ADVANCED ION BEAM TECHNOLOGY, INC.) 14 November 2013 (2013-11-14) entire document | 1-21 |

☐ Further documents are listed in the continuation of Box C.   ☑ See patent family annex.

| * | Special categories of cited documents: | "T" | later document published after the international filing date or priority date and not in conflict with the application but cited to understand the principle or theory underlying the invention |
|---|---|---|---|
| "A" | document defining the general state of the art which is not considered to be of particular relevance | | |
| "D" | document cited by the applicant in the international application | "X" | document of particular relevance; the claimed invention cannot be considered novel or cannot be considered to involve an inventive step when the document is taken alone |
| "E" | earlier application or patent but published on or after the international filing date | | |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | "&" | document member of the same patent family |
| "P" | document published prior to the international filing date but later than the priority date claimed | | |

| Date of the actual completion of the international search | Date of mailing of the international search report |
|---|---|
| **30 August 2023** | **15 September 2023** |

| Name and mailing address of the ISA/CN | Authorized officer |
|---|---|
| **China National Intellectual Property Administration (ISA/CN)** **China No. 6, Xitucheng Road, Jimenqiao, Haidian District, Beijing 100088** | |
| | Telephone No. |

Form PCT/ISA/210 (second sheet) (July 2022)

**INTERNATIONAL SEARCH REPORT**
Information on patent family members

International application No.

**PCT/CN2023/102680**

| Patent document cited in search report | | | Publication date (day/month/year) | Patent family member(s) | | | Publication date (day/month/year) |
|---|---|---|---|---|---|---|---|
| CN | 110993474 | A | 10 April 2020 | CN | 110993474 | B | 16 July 2021 |
| CN | 104236426 | A | 24 December 2014 | CN | 04236426 | B | 13 June 2017 |
| CN | 106683966 | A | 17 May 2017 | CN | 106683966 | B | 07 May 2019 |
| JP | 2003139044 | A | 14 May 2003 | None | | | |
| US | 2013299722 | A1 | 14 November 2013 | None | | | |

Form PCT/ISA/210 (patent family annex) (July 2022)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- CN 202211578850